# EUROPEAN PATENT APPLICATION

(11) **EP 4 036 040 A1**
(43) Date of publication of application: **03.08.2022**
(21) Application number: 20869185.7
(22) Date of filing: 28.08.2020
(51) Int. Cl.: B65H 41/00, H01L 21/683

(54) **PROTECTIVE SHEET SEPARATION DEVICE AND PROTECTIVE SHEET SEPARATION METHOD**

(30) Priority: 25.09.2019 JP 2019174680
(71) Applicant: OMRON Corporation, Shiokoji-dori, Shimogyo-Ku Kyoto-shi Kyoto 600-8530 (JP)
(72) Inventor: MAEDA, Toshiaki, Kyoto-shi, Kyoto 600-8530 (JP); SHUKUTANI, Masato, Kyoto-shi, Kyoto 600-8530 (JP); ISAYAMA, Takuo, Kyoto-shi, Kyoto 600-8530 (JP); NAKAJIMA, Akihei, Kyoto-shi, Kyoto 600-8530 (JP)
(74) Representative: Carstens, Dirk Wilhelm
(86) International application number: PCT/JP2020/032495
(87) International publication number: WO 2021/059854

(57) **Abstract**

Provided is a protective sheet separation device with a simple configuration. The protective sheet separation device (1) comprises attaching units (23, 33) that are furnished with separation tape (T1, T2) to be attached to protective sheets (C1, C2) attached to an adherend body (B1), gripping units (41, 42) that grip a portion of the protective sheets (C1, C2) separated from the adherend body (B1) and not attached to the separation tape (T1, T2), and a moving unit (50) that holds the adherend body (B1). The entire protective sheet (C1, C2) is separated from the adherend body (B1) by way of the moving unit (50) moving away from the gripping unit (41, 42).

## Description

### [Technical Field]

The present invention relates to a protective sheet separation device and a protective sheet separation method.

### [Background Art]

Conventionally, for example, when semiconductors and electronic displays are manufactured, in order to prevent generation of scratches and attaching of foreign matter on surfaces of their constituent members, a protective sheet may be attached to the constituent members. When this protective sheet is separated from the constituent members, a method of attaching a separation tape to the protective sheet and pulling the separation tape, thereby separating the protective sheet together with the separation tape is performed.

In order to reduce a consumption amount of a separation tape, for example, Patent Literature 1 discloses a sheet separation device that separates a protective sheet from a separation tape using a gripping means. Specifically, the gripping means grips an end portion of the protective sheet that has been separated from an adherend body which is a constituent member, and then rotates it in a direction of separation from the separation tape, and thus the protective sheet and the separation tape are separated.

### [Citation List]

### [Patent Literature]

[Patent Literature 1]
Japanese Patent No. 5103322

### [Summary of Invention]

### [Technical Problem]

However, the above-mentioned conventional technique has a problem that, since the gripping means needs to be rotationally driven in order to separate the protective sheet from the separation tape, a structure of the sheet separation device becomes complicated.

An objective of one aspect of the present invention is to realize a protective sheet separation device with a simple configuration.

### [Solution to Problem]

As an example of the present disclosure, the following configuration is adopted in order to solve the above-mentioned problems.

That is, a protective sheet separation device according to one aspect of the present invention includes: an attaching unit to which a separation tape is attached, which is movable relative to an adherend body to which a protective sheet is attached, and which presses the separation tape to be attached to the protective sheet by performing a relative movement in a direction of coming closer to the adherend body; a gripping unit that grips a portion of the protective sheet that has been separated from the adherend body by performing a relative movement of the attaching unit in a direction of moving away from the adherend body and is not attached to the separation tape; and a moving unit that is movable relative to the gripping unit, holds the adherend body, and separates the entire protective sheet from the adherend body by performing a relative movement in a direction of moving away from the gripping unit.

Also, a protective sheet separation method according to one aspect of the present invention includes: an attaching step of pressing a separation tape to be attached to a protective sheet that has been attached to an adherend body; a partial separation step of relatively moving the separation tape relative in a direction of moving away from the adherend body to partially separate the protective sheet from the adherend body; a gripping step of gripping a portion of the protective sheet, which has been separated from the adherend body and is not attached to the separation tape, using a gripping unit; and a full separation step of relatively moving the adherend body in a direction of moving away from the gripping unit, thereby separating the entire protective sheet from the adherend body.

### [Advantageous Effects of Invention]

According to one aspect of the present invention, a protective sheet separation device with a simple configuration can be realized.

### [Brief Description of Drawings]

Fig. 1 is a schematic side view showing an initial state of a protective sheet separation device according to the present embodiment.
Fig. 2 is an enlarged cross-sectional view of an adherend body to which an upper protective sheet and a lower protective sheet are attached, which are separated by the protective sheet separation device according to Fig. 1.
Fig. 3 is a top view of a delivery chuck shown in Fig. 1.
Fig. 4 is a front schematic view of the protective sheet separation device in the initial state according to Fig. 1.
Fig. 5 is a block diagram showing a configuration of a control device included in the protective sheet separation device shown in Fig. 1.
Fig. 6 is a diagram showing a state in which an upper attaching roller and a lower attaching roller are brought closer to each other in the protective sheet separation device according to Fig. 1.
Fig. 7 is a diagram showing a state in which a front end portion of a workpiece is disposed between the upper attaching roller and the lower attaching roller in the protective sheet separation device according to Fig. 6.
Fig. 8 is a diagram showing a state in which an upper separation tape and a lower separation tape are moved in the protective sheet separation device according to Fig. 7.
Fig. 9 is a diagram showing a state in which the upper attaching roller and the lower attaching roller are caused to move away from the adherend body in the protective sheet separation device according to Fig. 8.
Fig. 10 is a diagram showing a state in which the upper protective sheet and the lower protective sheet are gripped respectively by an upper separation chuck and a lower separation chuck in the protective sheet separation device according to Fig. 9.
Fig. 11 is a diagram showing a state in which the upper attaching roller and the lower attaching roller are caused to move away respectively from the upper separation chuck and the lower separation chuck in the protective sheet separation device according to Fig. 10.
Fig. 12 is a diagram showing a state in which the upper protective sheet and the lower protective sheet are separated respectively from the upper separation tape and the lower separation tape in the protective sheet separation device according to Fig. 11.
Fig. 13 is a diagram showing a state in which the delivery chuck is open and the adherend body gripped by a receiving chuck is advanced in the protective sheet separation device according to Fig. 12.
Fig. 14 is a diagram showing a state in which the upper protective sheet and the lower protective sheet are separated from the adherend body in the protective sheet separation device according to Fig. 13.
Fig. 15 is a front schematic view of the protective sheet separation device according to Fig. 14.
Fig. 16 is a diagram showing a state in which the upper separation chuck and the lower separation chuck according to Fig. 15 are rotated and moved to above a dust box.
Fig. 17 is a flowchart showing a method of separating the upper protective sheet and the lower protective sheet from the adherend body.
Fig. 18 is a diagram showing a modified example of the upper separation chuck shown in Fig. 1.
Fig. 19 is a diagram showing a modified example of a moving unit.
Fig. 20 is a diagram showing a modified example of an attaching unit.

### [Description of Embodiments]

An embodiment according to one aspect of the present invention (hereinafter, also referred to as "the present embodiment") will be described below with reference to the drawings.

### [First embodiment]

### § 1 Application example

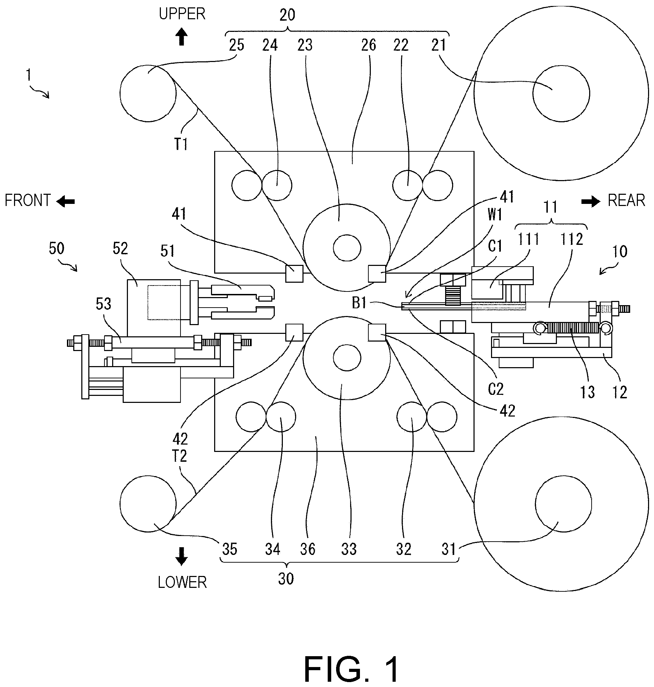

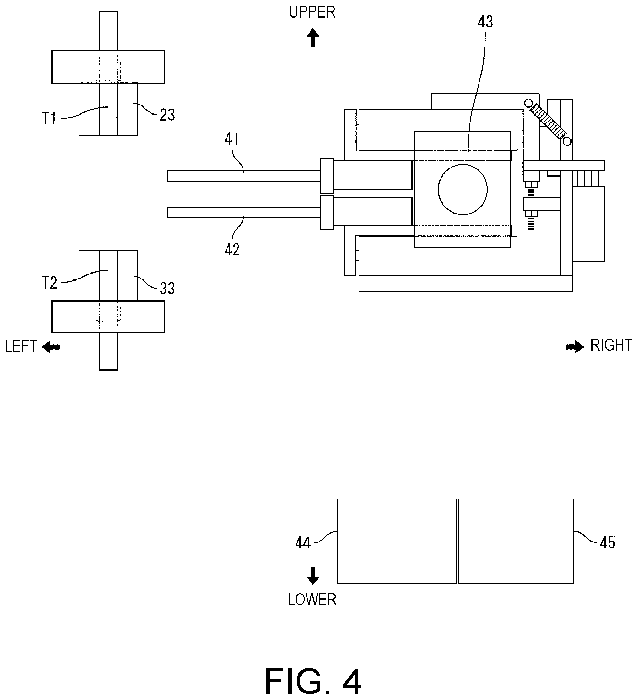

First, an example of a situation to which the present invention is applied will be described with reference to Figs. 1 and 4. Fig. 1 is a schematic side view showing an initial state of a protective sheet separation device 1 according to the present embodiment. Fig. 4 is a schematic front view of the protective sheet separation device 1 in the initial state. As shown in Figs. 1 and 4, the protective sheet separation device 1 includes a delivery unit 10, an upper tape holding unit (a tape drive unit) 20, a lower tape holding unit (a tape drive unit) 30, an upper separation chuck (a gripping unit) 41, a lower separation chuck (a gripping unit) 42, a separation chuck rotating cylinder 43, and a receiving unit (a moving unit) 50. Fig. 4 is illustrated with the delivery unit 10, the receiving unit 50, and the like omitted.

In the following description, in the protective sheet separation device 1 shown in Fig. 1, sides on which the delivery unit 10 and the receiving unit 50 are disposed are referred to as a "rear side" and a "front side," respectively. Also, sides on which the upper tape holding unit 20 and the lower tape holding unit 30 are disposed are referred to as an "upper side" and "lower side," respectively. Further, in the protective sheet separation device 1 shown in Fig. 4 and the like, a right side of the paper surface is referred to as a "right side" and a left side of the paper surface is referred to as a "left side."

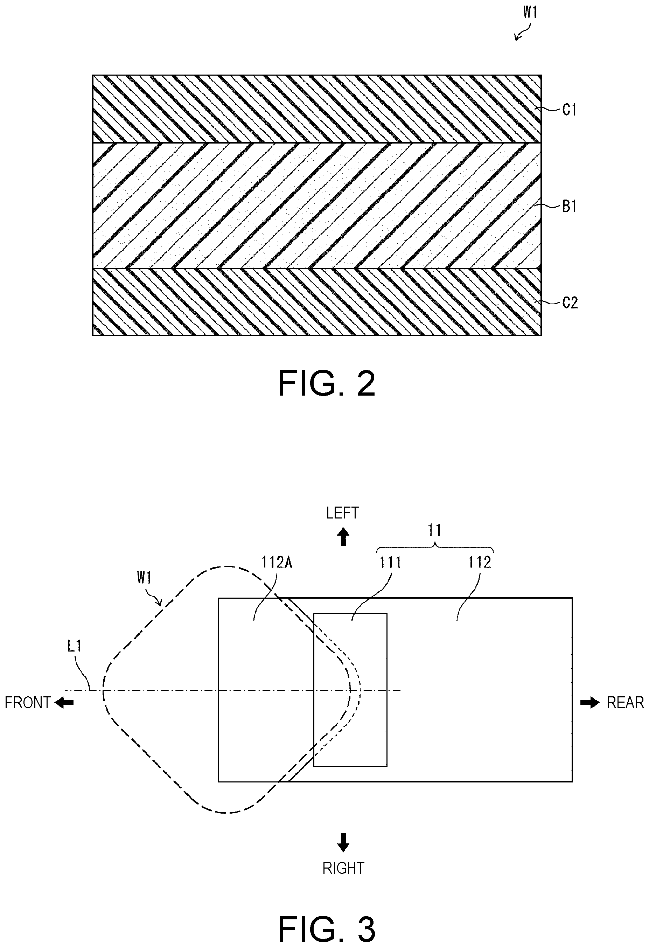

Fig. 2 is an enlarged cross-sectional view of a workpiece W1 shown in Fig. 1. As shown in Fig. 2, in the workpiece W1, an upper protective sheet C1 is attached to an upper surface of an adherend body B1, and a lower protective sheet C2 is attached to a lower surface of the adherend body B1. As an example of the adherend body B1, a resin plate, a sheet metal, and a glass plate, in addition to a constituent sheet and a semiconductor wafer of an electronic display can be exemplified.

The upper tape holding unit 20 includes an upper attaching roller (an attaching unit) 23, and the lower tape holding unit 30 includes a lower attaching roller (an attaching unit) 33. An upper separation tape T1 and a lower separation tape T2 are attached respectively to the upper attaching roller 23 and the lower attaching roller 33.

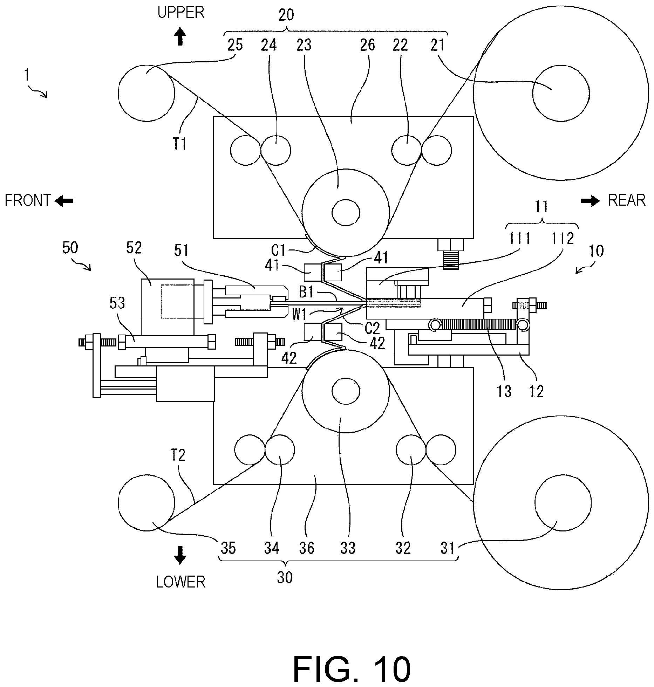

As will be described later with respect to Fig. 10, the upper separation chuck 41 grips a portion of the upper protective sheet C1 that has been separated from the adherend body B1 and is not attached to the upper separation tape T1. Similarly, the lower separation chuck 42 grips a portion of the lower protective sheet C2 that has been separated from the adherend body B1 and is not attached to the lower separation tape T2.

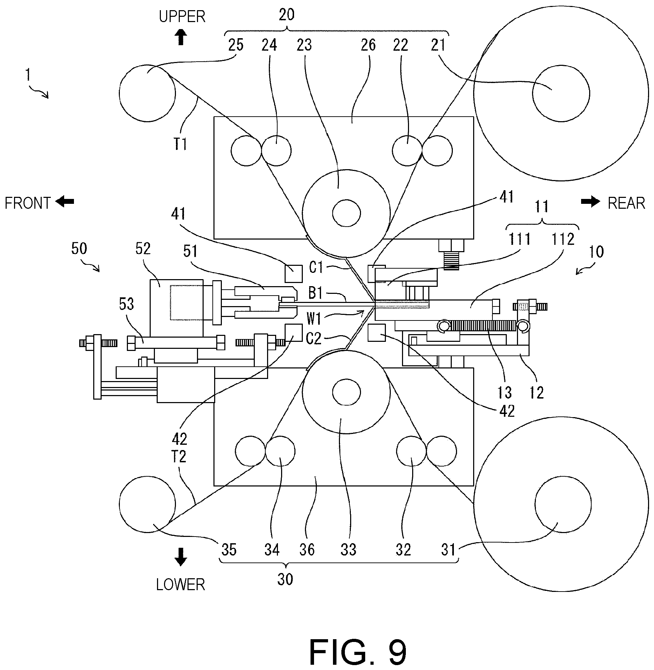

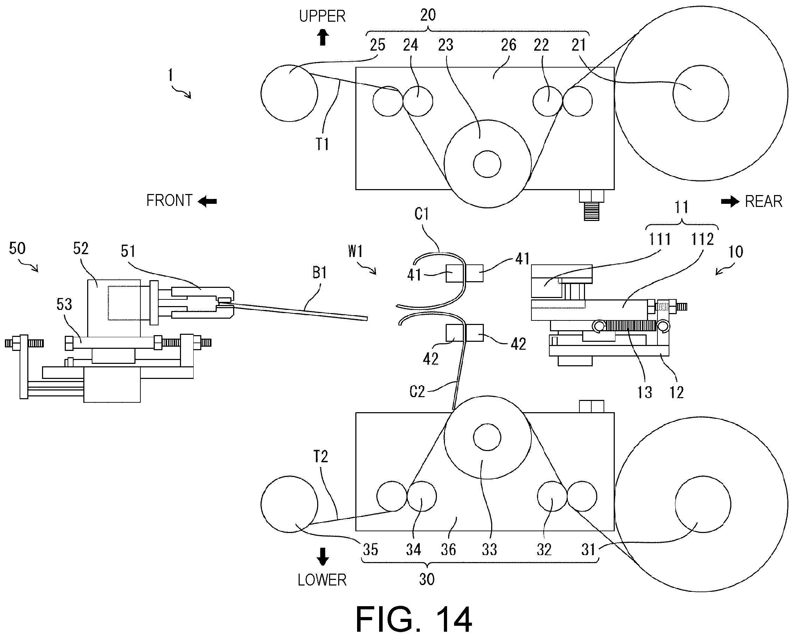

As will be described later with respect to Fig. 9, the receiving unit 50 holds the adherend body B1. Then, as will be described later with respect to Fig. 14, the receiving unit 50 moves relative to the upper separation chuck 41 and the lower separation chuck 42 in a direction of moving away from them, thereby separating the entire upper protective sheet C1 and the entire lower protective sheet C2 from the adherend body B1.

Accordingly, according to the present embodiment, there is no need to use a rotary drive method to separate the upper protective sheet C1 and the lower protective sheet C2 from the adherend body B1, and the protective sheet separation device 1 with a simple configuration can be realized.

### §2 Configuration example

### (Delivery unit 10)

As shown in Fig. 1, the delivery unit 10 holds the workpiece W1 and delivers it to the receiving unit 50. The delivery unit 10 includes a delivery chuck 11, a delivery chuck support unit 12, and a spring 13, and is driven by a power source (not shown) to be movable in a front to rear direction. The delivery chuck 11 is configured to grip a rear end portion of the workpiece W1 and includes a chuck upper unit 111 and a chuck lower unit 112. The delivery chuck support unit 12 supports the delivery chuck 11 to be relatively movable in the front to rear direction. The spring 13 connects the delivery chuck 11 to the delivery chuck support unit 12 and biases the delivery chuck 11 to the rear side. As will be described later, due to the biasing force of the spring 13, the delivery unit 10 delivers the workpiece W1 to the receiving unit 50, and then the delivery chuck 11 retracts to an origin position.

Fig. 3 is a top view of the delivery chuck 11. As shown in Fig. 3, for example, in a case in which the delivery chuck 11 grips the workpiece W1 having a substantially rectangular shape with rounded corners, the workpiece W1 may be disposed such that a diagonal line L1 of the workpiece W1 is oriented in the front to rear direction. In this case, in order for the delivery chuck 11 to securely grip the workpiece W1, a thinned portion 112A may be formed on the chuck lower unit 112. A shape of the thinned portion 112A on the rear side is a curve along a shape of a rear portion of the workpiece W1.

### (Upper tape holding unit 20)

As shown in Figs. 1 and 2, the upper tape holding unit 20 holds the upper separation tape T1 for separating the upper protective sheet C1 attached to the adherend body B1. The upper separation tape T1 is a pressure-sensitive adhesive tape. The upper tape holding unit 20 includes an upper feeding roller 21, a pair of first upper pinch rollers 22, an upper attaching roller (an attaching unit) 23, a pair of second upper pinch rollers 24, an upper winding roller 25, and an upper movable unit 26.

In the initial state of the protective sheet separation device 1 shown in Fig. 1, the upper feeding roller 21 and the upper winding roller 25 are located substantially directly above the delivery unit 10 and the receiving unit 50, respectively. A position of the upper attaching roller 23 in the front to rear direction is near a middle position between the upper feeding roller 21 and the upper winding roller 25. A position of the upper attaching roller 23 in a vertical direction is below the upper feeding roller 21 and the upper winding roller 25 and slightly above the delivery unit 10 and the receiving unit 50.

The pair of first upper pinch rollers 22 are located between the upper feeding roller 21 and the upper attaching roller 23 and are arranged in the front to rear direction. Further, the pair of second upper pinch rollers 24 are located between the upper winding roller 25 and the upper attaching roller 23 and are arranged in the front to rear direction. Each of the rollers 21 to 25 of the upper tape holding unit 20 has a substantially cylindrical shape and is disposed such that their rotation axes are substantially parallel to each other.

The upper feeding roller 21 rotatably supports the roll-shaped upper separation tape T1 that is wound thereon with its adhesive surface disposed inward. The upper separation tape T1 is supported by the upper feeding roller 21 such that the adhesive surface faces downward when the upper separation tape T1 is drawn out of the upper feeding roller 21.

The pair of first upper pinch rollers 22 are connected to an output shaft of a motor (not shown) and are configured such that they can feed the upper separation tape T1 with a desired tension by sandwiching the upper separation tape T1 drawn out of the upper feeding roller 21. Since a roller of the pair of first upper pinch rollers 22 located on the rear side is in contact with the adhesive surface side of the upper separation tape T1, for example, it is made of a metal and has a non-adhesive coating on its surface. Since a roller of the pair of first upper pinch rollers 22 located on the front side is in contact with a non-adhesive surface side of the upper separation tape T1, it may be made of, for example, stainless steel or rubber.

The upper attaching roller 23 presses the non-adhesive surface side of the upper separation tape T1 fed by the pair of first upper pinch rollers 22 from above. The upper attaching roller 23 is made of, for example, stainless steel.

The pair of second upper pinch rollers 24 are configured to sandwich the upper separation tape T1 pressed by the upper attaching roller 23 so that they can send the upper separation tape T1 to the upper winding roller 25. Since a roller of the pair of second upper pinch rollers 24 located on the front side is in contact with the adhesive surface side of the upper separation tape T1, for example, it is made of a metal and has a non-adhesive coating on its surface. Since a roller of the pair of second upper pinch rollers 24 located on the rear side is in contact with the non-adhesive surface side of the upper separation tape T1, it may be made of, for example, stainless steel or rubber.

The upper winding roller 25 is connected to an output shaft of a motor (not shown) and winds up the upper separation tape T1 sent by the pair of second upper pinch rollers 24. The upper movable unit 26 supports the first upper pinch rollers 22, the upper attaching roller 23, and the second upper pinch rollers 24 and is movable in the vertical direction by a power source (not shown).

### (Lower tape holding unit 30)

The lower tape holding unit 30 holds the lower separation tape T2 for separating the lower protective sheet C2 that has been attached to the adherend body B1 and is configured to be substantially vertically symmetrical with the upper tape holding unit 20. The lower tape holding unit 30 includes a pair of lower feeding rollers 31, a pair of first lower pinch rollers 32, a lower attaching roller (an attaching unit) 33, a pair of second lower pinch rollers 34, a lower winding roller 35, and a lower movable unit 36.

In the initial state of the protective sheet separation device 1 shown in Fig. 1, the lower feeding roller 31 and the lower winding roller 35 are located substantially directly below the delivery unit 10 and the receiving unit 50, respectively. A position of the lower attaching roller 33 in the front to rear direction is near a middle position between the lower feeding roller 31 and the lower winding roller 35. A position of the lower attaching roller 33 in the vertical direction is above the lower feeding roller 31 and the lower winding roller 35 and slightly below the delivery unit 10 and the receiving unit 50.

The pair of first lower pinch rollers 32 are located between the lower feeding roller 31 and the lower attaching roller 33 and are arranged in the front to rear direction. Also, the pair of second lower pinch rollers 34 are located between the lower winding roller 35 and the lower attaching roller 33 and are arranged in the front to rear direction. Each of the rollers 31 to 35 of the lower tape holding unit 30 has a substantially cylindrical shape and is disposed such that their rotation axes are substantially parallel to each other.

The lower feeding roller 31 rotatably supports the roll-shaped lower separation tape T2 that is wound thereon with its adhesive surface disposed inward. The lower separation tape T2 is supported by the lower feeding roller 31 such that the adhesive surface faces upward when it is drawn out from the lower feeding roller 31.

The pair of first lower pinch rollers 32 are connected to an output shaft of a motor (not shown) and is configured to sandwich the lower separation tape T2 drawn out from the lower feeding roller 31 so that the lower separation tape T2 can be fed with a desired tension. Since a roller of the pair of first lower pinch rollers 32 located on the rear side is in contact with the adhesive surface side of the lower separation tape T2, it is made of, for example, a metal and has a non-adhesive coating on its surface. Since a roller of the pair of first lower pinch rollers 32 located on the front side is in contact with the non-adhesive surface side of the lower separation tape T2, it may be made of, for example, stainless steel or rubber.

The lower attaching roller 33 presses the non-adhesive surface side of the lower separation tape T2 fed by the pair of first lower pinch rollers 32 from below. The lower attaching roller 33 is made of, for example, stainless steel. The lower attaching roller 33 is disposed below the upper attaching roller 23 substantially parallel to the upper attaching roller 23.

The pair of second lower pinch rollers 34 are configured to sandwich the lower separation tape T2 pressed by the lower attaching roller 33 so that they can send the lower separation tape T2 to the lower winding roller 35. Since a roller of the pair of second lower pinch rollers 34 located on the front side is in contact with the adhesive surface side of the lower separation tape T2, it is made of, for example, a metal and has a non-adhesive coating on its surface. Since a roller of the pair of second lower pinch rollers 34 located on the rear side is in contact with the non-adhesive surface side of the lower separation tape T2, it may be made of, for example, stainless steel or rubber.

The lower winding roller 35 is connected to an output shaft of a motor (not shown) and winds up the lower separation tape T2 sent by the pair of second lower pinch rollers 34. The lower movable unit 36 supports the first lower pinch rollers 32, the lower attaching roller 33, and the second lower pinch rollers 34, and is movable in the vertical direction by a power source (not shown).

In the following description, for each of the rollers 21 to 25 of the upper tape holding unit 20, a rotation in a direction in which the upper separation tape T1 is sent from the upper feeding roller 21 to the upper winding roller 25 is referred to as a "forward rotation," and a rotation reverse to the forward rotation is referred to as a "reverse rotation." For example, in the case of the upper attaching roller 23, a rotation in which a lower portion of the upper attaching roller 23 advances is the forward rotation, and a rotation in which it retracts is the reverse rotation.

Similarly, with respect to a rotation direction of each of the rollers 31 to 35 of the lower tape holding unit 30, a rotation in a direction in which the lower separation tape T2 is sent from the lower feeding roller 31 to the lower winding roller 35 is referred to as a "forward rotation," a rotation reverse to the forward rotation is referred to as a "reverse rotation." For example, in the case of the lower attaching roller 33, a rotation in a direction in which an upper portion of the lower attaching roller 33 advances is the forward rotation, and a rotation in which it retracts is the reverse rotation.

### (Upper separation chuck 41)

As will be described later, the upper separation chuck 41 grips a portion of the upper protective sheet C1 that is separated from the adherend body B1 and is not attached to the upper separation tape T1. Specifically, the upper separation chuck 41 grips a portion of the upper protective sheet C1 partially separated from the adherend body B1 between a portion attached to the separation tape T1 and a portion attached to the adherend body B1.

As shown in Fig. 1, in the initial state of the protective sheet separation device 1, the upper separation chuck 41 is disposed slightly below the upper attaching roller 23 on the right side. As will be described later, the upper separation chuck 41 is configured to extend leftward and move between the upper attaching roller 23 and the lower attaching roller 33 at the time of gripping the upper protective sheet C1.

### (Lower separation chuck 42)

The lower separation chuck 42 grips a portion of the lower protective sheet C2 that is separated from the adherend body B1 and is not attached to the lower separation tape T2. Specifically, the lower separation chuck 42 grips a portion of the lower protective sheet C2 partially separated from the adherend body B1 between a portion attached to the separated tape T2 and a portion attached to the adherend body B1. In the initial state of the protective sheet separation device 1, the lower separation chuck 42 is disposed slightly above the lower attaching roller 33 on the right side. As will be described later, the lower separation chuck 42 is configured to extend leftward and move between the upper attaching roller 23 and the lower attaching roller 33 at the time of gripping the lower protective sheet C2.

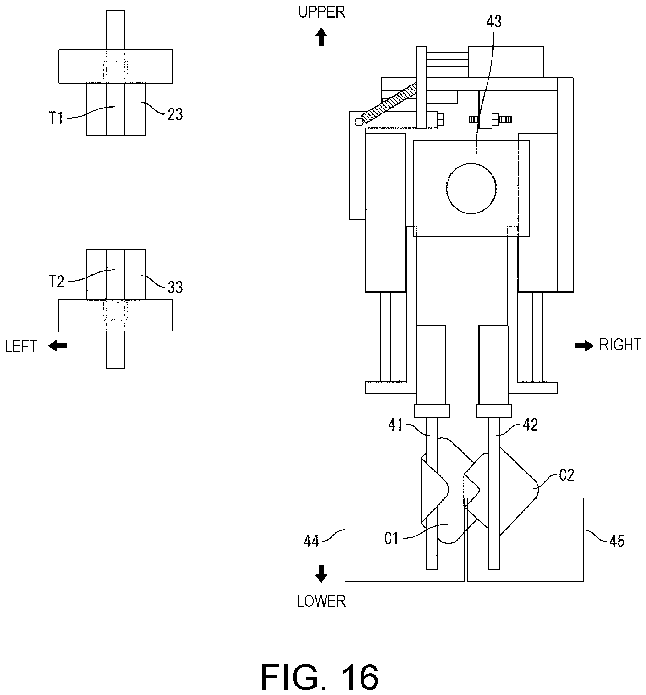

The separation chuck rotating cylinder 43 rotates and moves the upper separation chuck 41 and the lower separation chuck 42 along a vertical plane between an initial state shown in Fig. 4 and a discard position above dust boxes 44 and 45 shown in Fig. 16.

The dust boxes 44 and 45 are boxes into which the upper protective sheet C1 and the lower protective sheet C2 separated from the adherend body B1 are discarded. In other words, discarded positions of the separated upper protective sheet C1 and lower protective sheet C2 are in the dust box 44 and the dust box 45, respectively.

### (Receiving unit 50)

The receiving unit 50 is configured to receive and hold the adherend body B1 advanced to a delivery position, which will be described later, and to be movable in the front to rear direction by a power source (not shown). The receiving unit 50 includes a pair of receiving chucks 51, a receiving chuck support unit 52, and a fixed cylinder 53. As will be described later, the pair of receiving chucks 51 grip a portion of the adherend body B 1 from which the upper protective sheet C1 and the lower protective sheet C2 have been separated. Positions of the receiving chuck 51 and the delivery chuck 11 in the vertical direction are substantially the same. The receiving chuck support unit 52 supports the pair of receiving chucks 51. The fixed cylinder 53 allows the receiving chuck support unit 52 to move in the front to rear direction in an open state, and fixes the receiving chuck support unit 52 in a fixed state.

### (Control device)

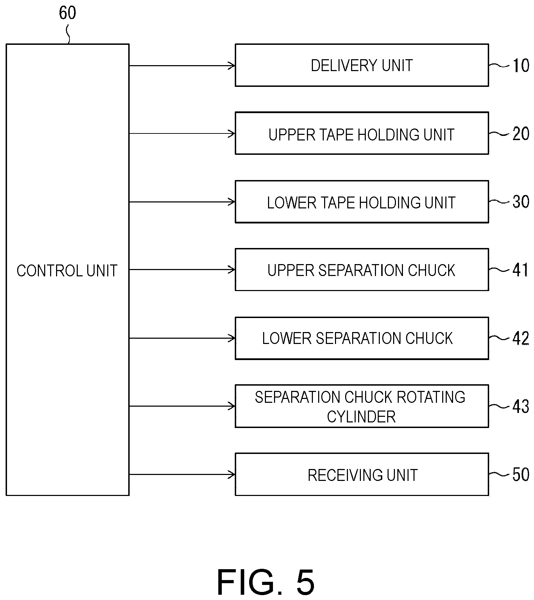

Fig. 5 is a block diagram showing a configuration of a control device included in the protective sheet separation device 1. The control device includes a control unit 60. The delivery unit 10, the upper tape holding unit 20, the lower tape holding unit 30, the upper separation chuck 41, the lower separation chuck 42, the separation chuck rotating cylinder 43, and the receiving unit 50 are connected to the control unit 60. The control unit 60 controls operations of them.

### §3 Operation example

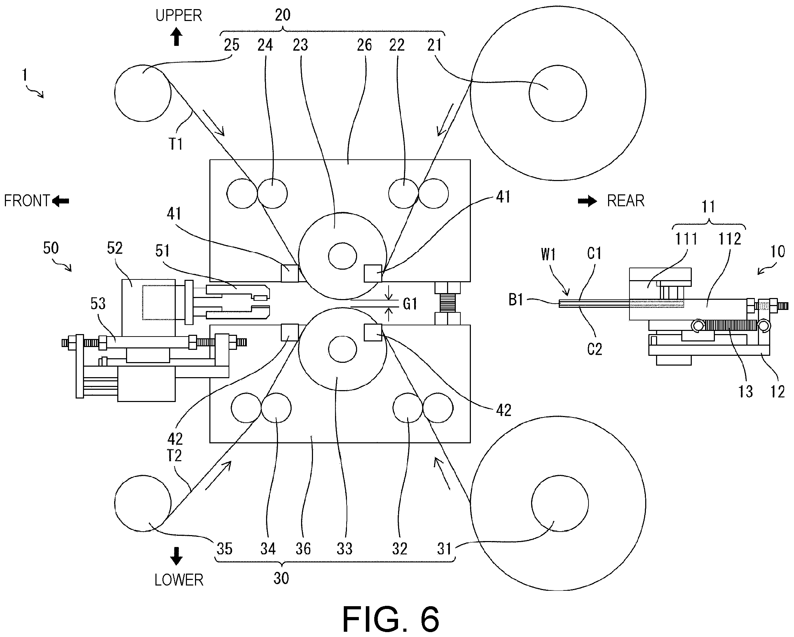

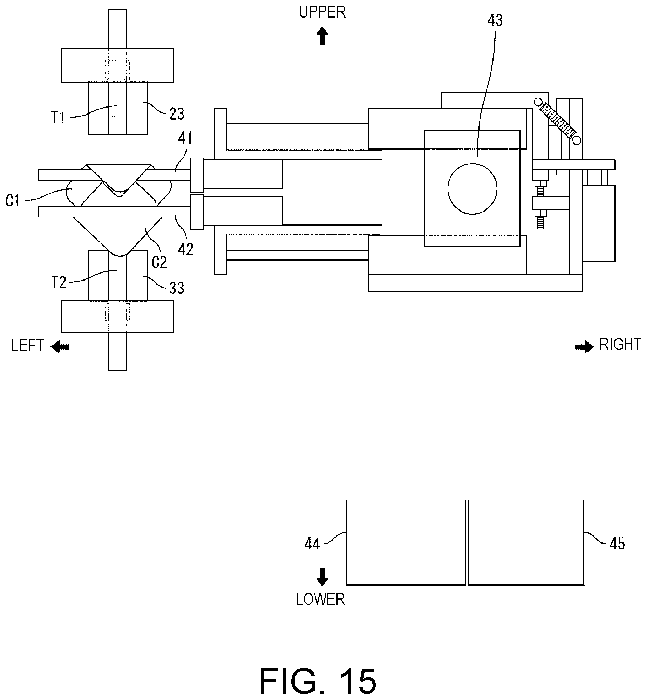

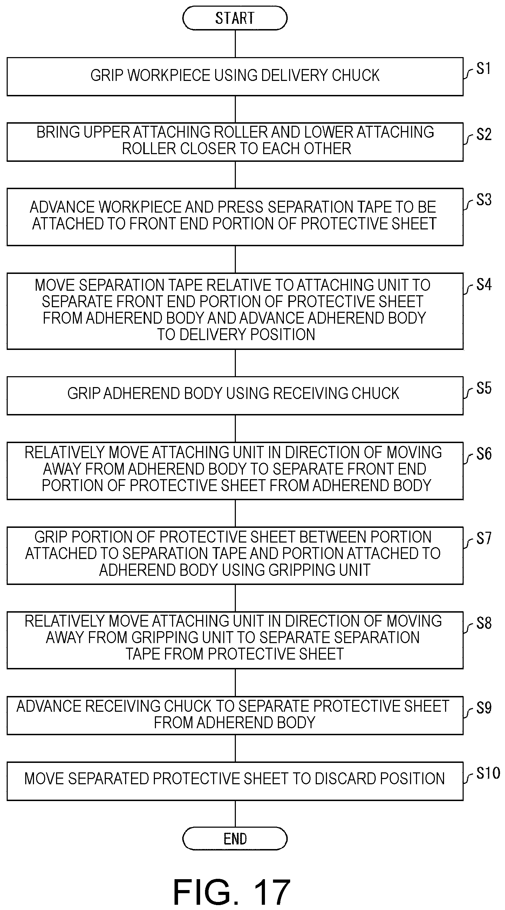

A method of separating the upper protective sheet C1 and the lower protective sheet C2 from the adherend body B1 using the protective sheet separation device 1 will be described with reference to Figs. 1, 3, and 6 to 17. Figs. 6 to 14 are schematic side views of the protective sheet separation device 1 showing a process of separating the upper protective sheet C1 and the lower protective sheet C2 from the adherend body B1. Figs. 15 and 16 are schematic front views of the protective sheet separation device 1 showing a process of moving the separated upper protective sheet C1 and lower protective sheet C2 to the discard position. Fig. 17 is a flowchart showing a separating method of the upper protective sheet C1 and the lower protective sheet C2 using the protective sheet separation device 1. Also, an S (step) number used in the following description is an S number shown in Fig. 17.

In order to separate the upper protective sheet C1 and the lower protective sheet C2 from the adherend body B1, first, as shown in Fig. 1, the workpiece W1 is gripped by the delivery chuck 11 (S1). In this case, as shown in Fig. 3, for example, in a case in which the delivery chuck 11 grips the workpiece W1 having a substantially rectangular shape with rounded corners, the workpiece W1 may be disposed such that a diagonal line L1 of the workpiece W1 is oriented in the front to rear direction. In this case, a rounded corner portion of the upper protective sheet C1 or the lower protective sheet C2 are located on the front side.

Next, as shown in Fig. 6, by lowering the upper movable unit 26 and raising the lower movable unit 36, the upper attaching roller 23 and the lower attaching roller 33 are brought closer to each other (S2). In this case, in order to prevent a tension of the upper separated tape T1 from becoming excessively large, the pair of first upper pinch rollers 22 and the upper winding roller 25 may feed the upper separation tape T1 toward the upper attaching roller 23.

Also, in order to prevent a tension of the lower separation tape T2 from becoming excessively large, the pair of first lower pinch rollers 32 and the lower winding roller 35 may feed the lower separation tape T2 toward the lower attaching roller 33. A gap G1 between the upper attaching roller 23 and the lower attaching roller 33 is preferably set to be slightly smaller than a total thickness of the workpiece W1.

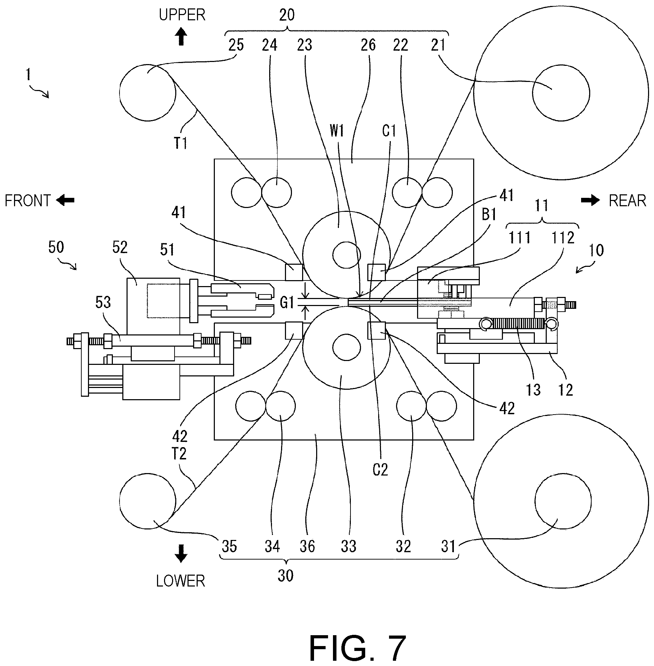

Next, as shown in Fig. 7, the delivery unit 10 is advanced, and a front end portion (a peripheral edge portion) of the workpiece W1 is disposed between the upper attaching roller 23 and the lower attaching roller 33. The front end portion of the workpiece W1 may be a rounded corner portion as described above in Fig. 3. In this case, since the gap G1 is set to be slightly smaller than the total thickness of the workpiece W1, the upper attaching roller 23 presses the front end portion of the workpiece W1 from above via the upper separation tape T1. Since the upper attaching roller 23 presses the non-adhesive surface of the upper separation tape T1 from above, the adhesive surface of the upper separation tape T1 is pressed and attached to the front end portion of the workpiece W1, in other words, a front end portion of the upper protective sheet C1 attached to the adherend body B1 (an attachment step S3).

Similarly, the lower attaching roller 33 presses the front end portion of the workpiece W1 from below via the lower separation tape T2. Since the lower attaching roller 33 presses the non-adhesive surface of the lower separation tape T2, the adhesive surface of the lower separation tape T2 is pressed and attached to the front end portion of the workpiece W1, in other words, a front end portion of the lower protective sheet C2 attached to the adherend body B1. A pressing load generated by the upper attaching roller 23 and the lower attaching roller 33 may be appropriately changed depending on materials, sizes or shapes of the adherend body B1, the upper protective sheet C1, and the lower protective sheet C2, and it may be 5 N or more, for example. The pressing load can be changed by changing the gap G1.

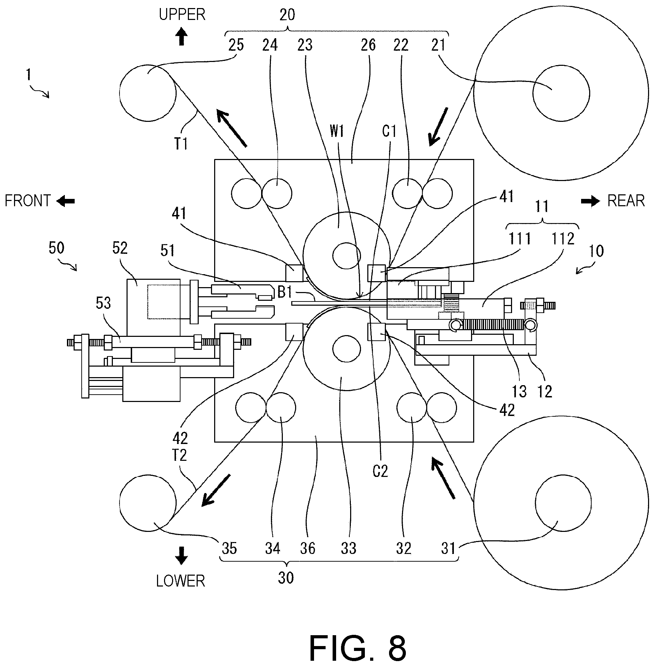

Next, as shown in Fig. 8, each of the rollers 21 to 25 of the upper tape holding unit 20 is rotated forward. Thus, the upper separation tape T1 is sent from the upper feeding roller 21 toward the upper winding roller 25. Similarly, each of the rollers 31 to 35 of the lower tape holding unit 30 is rotated forward. Thus, the lower separation tape T2 is sent from the lower feeding roller 31 toward the lower winding roller 35.

The rollers 22 to 25 of the upper tape holding unit 20 and the rollers 32 to 35 of the lower tape holding unit 30 are configured to be rotated by drive of a motor. On the other hand, the upper feeding roller 21 and the lower feeding roller 31 may be configured to rotate on driven sides.

As a result, the front end portion of the upper protective sheet C1 to which the upper separation tape T1 is attached moves in a direction of the second upper pinch rollers 24 along with the upper separation tape T1 and is separated from the adherend body B1 (S4). Similarly, the front end portion of the lower protective sheet C2 to which the lower separation tape T2 is attached moves in a direction of the second lower pinch rollers 34 along with the lower separation tape T2 and is separated from the adherend body B1.

As described above in Fig. 3, in a case in which the front end portions of the upper protective sheet C1 and the lower protective sheet C2 are rounded corner portions, it is preferable because the front end portions of the upper protective sheet C1 and the lower protective sheet C2 are more reliably separated from the adherend body B1.

As the upper separation tape T1 and the lower separation tape T2 move, the workpiece W1 advances to the delivery position. At the delivery position of the workpiece W1, the receiving unit 50 can hold the adherend body B1. In this case, the delivery chuck 11 that grips the workpiece W1 advances with respect to the delivery chuck support unit 12, and elastic energy is accumulated in the spring 13. In addition, in order to prevent the elastic energy stored in the spring 13 from becoming larger than necessary, the delivery chuck support unit 12 may be advanced at a speed slower than the advance speed of the delivery chuck 11.

Next, as shown in Fig. 9, the portion of the adherend body B1 from which the upper protective sheet C1 and the lower protective sheet C2 have been separated is held by the receiving chuck 51, and the fixed cylinder 53 is opened (S5). Then, by raising the upper movable unit 26 and lowering the lower movable unit 36, the upper attaching roller 23 and the lower attaching roller 33 are moved away from the adherend body B1.

Thus, the upper separation tape T1 attached to the upper attaching roller 23 pulls the upper protective sheet C1 upward, and a front portion of the upper protective sheet C1 is separated from the adherend body B1 (a partial separation step S6). Similarly, the lower separation tape T2 attached to the lower attaching roller 33 pulls the lower protective sheet C2 downward, and a front portion of the lower protective sheet C2 is separated from the adherend body B1. In this case, since the fixed cylinder 53 is open, the receiving chuck 51 is pushed by the adherend body B1 to advance. Since rear portions of the upper protective sheet C1 and the lower protective sheet C2 are gripped by the delivery chuck 11, they are still attached to the adherend body B1.

Next, as shown in Fig. 10, the portion of the upper protective sheet C1 between the portion attached to the upper separation tape T1 and the portion attached to the adherend body B1 is gripped by the upper separation chuck 41 (a gripping step S7). Similarly, the portion of the lower protective sheet C2 between the portion attached to the lower separation tape T2 and the portion attached to the adherend body B1 is gripped by the lower separation chuck 42.

In this case, in order to prevent the tension of the upper separation tape T1 from becoming excessively large, the pair of first upper pinch rollers 22 and the upper winding roller 25 may feed the upper separation tape T1 toward the upper attaching roller 23, if necessary. Similarly, in order to prevent the tension of the lower separation tape T2 from becoming excessively large, the pair of first lower pinch rollers 32 and the lower winding roller 35 may feed the lower separation tape T2 toward the lower attaching roller 33, if necessary.

After step S7, the rollers 21 to 25 of the upper tape holding unit 20 and the rollers 31 to 35 of the lower tape holding unit 30 may be rotated reversely. In other words, the upper separation tape T1 may be relatively moved such that a portion farthest from the upper separation chuck 41 among portions of the upper protective sheet C1 to which the upper separation tape T1 is attached comes closer to a position of a portion closest to the upper separation chuck 41 among portions of the upper protective sheet C1 to which the upper separation tape T1 is attached.

Similarly, the lower separation tape T2 may be relatively moved such that a portion farthest from the lower separation chuck 42 among portions of the lower protective sheet C2 to which the lower separation tape T2 is attached comes closer to a position of a portion closest to the lower separation chuck 42 among portions of the lower protective sheet C2 to which the lower separation tape T2 is attached. In a case in which each of the rollers 21 to 25 of the upper tape holding unit 20 and each of the rollers 31 to 35 of the lower tape holding unit 30 are rotated reversely in this way, in step S8, which will be described later, the upper protective sheet C1 and the upper separation tape T1 are easily separated.

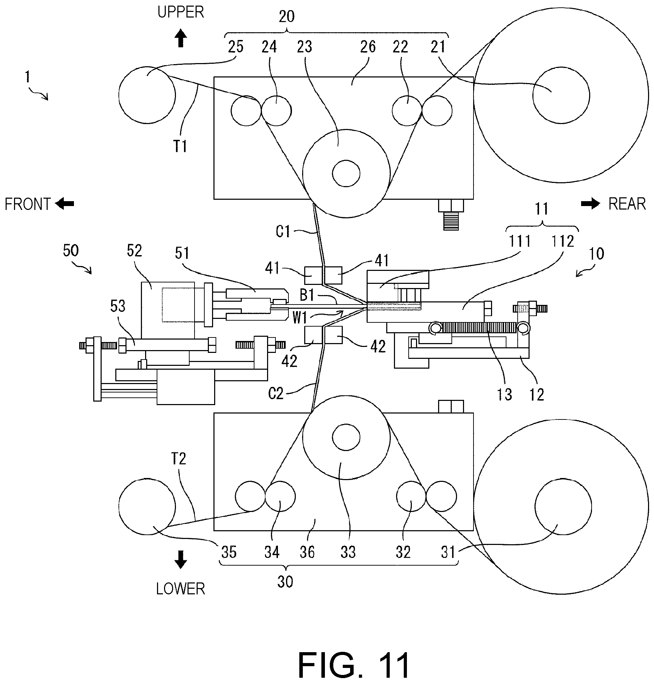

Next, as shown in Fig. 11, by raising the upper movable unit 26 and lowering the lower movable unit 36, the upper attaching roller 23 and the lower attaching roller 33 are further separated from the adherend body B1. In other words, the upper separation tape T1 attached to the upper attaching roller 23 is moved away from the upper separation chuck 41, and the lower separation tape T2 attached to the lower attaching roller 33 is moved away from the lower separation chuck 42. Thus, the upper protective sheet C1 gripped by the upper separation chuck 41 is separated from the upper separation tape T1, and the lower protective sheet C2 gripped by the lower separation chuck 42 is separated from the lower separation tape T2.

In Fig. 11, a distance between the portion of the upper separation tape T1 to which the front end portion of the upper protective sheet C1 is attached and the upper separation chuck 41 is equal to a length from the front end portion of the upper protective sheet C1 to the portion gripped by the upper separation chuck 41. Also, a distance between the portion of the lower separation tape T2 to which the front end portion of the lower protective sheet C2 is attached and the lower separation chuck 42 is equal to a length from the front end portion of the lower protective sheet C2 to the portion gripped by the lower separation chuck 42.

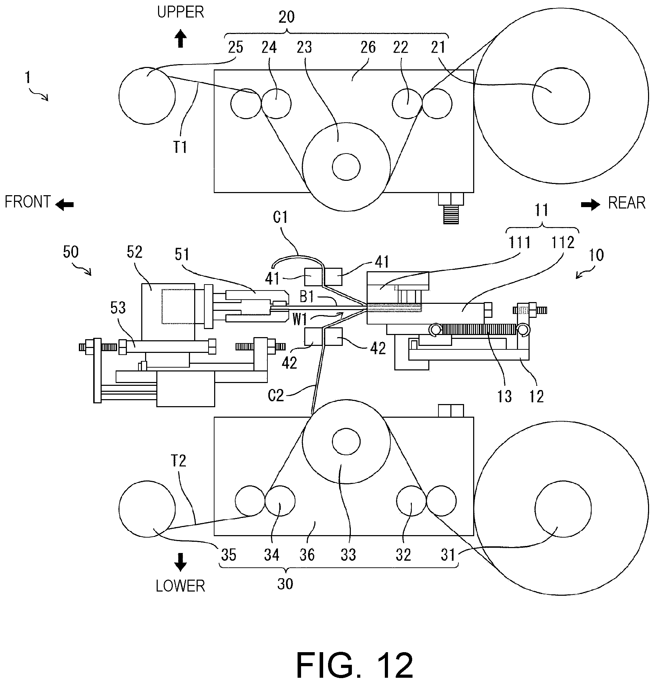

Next, as shown in Fig. 12, by further raising the upper movable unit 26 and further lowering the lower movable unit 36, the upper attaching roller 23 and the lower attaching roller 33 are further separated from the adherend body B1. In other words, the upper separation tape T1 attached to the upper attaching roller 23 is moved away from the upper separation chuck 41, and the lower separation tape T2 attached to the lower attaching roller 33 is further separated from the lower separation chuck 42.

In Fig. 12, the distance between the portion of the upper separation tape T1 to which the front end portion of the upper protective sheet C1 is attached and the upper separation chuck 41 is longer than the length from the front end portion of the upper protective sheet C1 to the portion gripped by the upper separation chuck 41. Further, the distance between the portion of the lower separation tape T2 to which the front end portion of the lower protective sheet C2 is attached and the lower separation chuck 42 is longer than the length from the front end portion of the lower protective sheet C2 to the portion gripped by the lower separation chuck 42. Accordingly, the entire upper protective sheet C1 gripped by the upper separation chuck 41 is separated from the upper separation tape T1, and the entire lower protective sheet C2 gripped by the lower separation chuck 42 is separated from the lower separation tape T2 (a separation step S8).

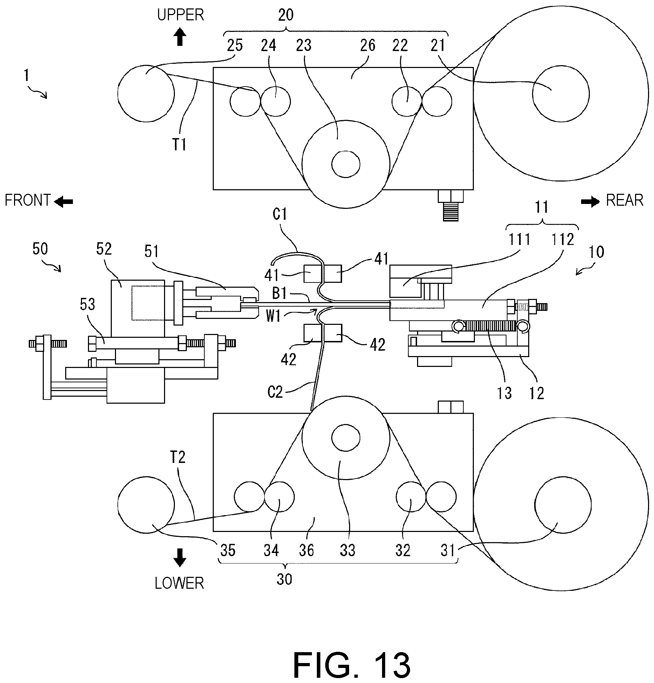

Next, as shown in Fig. 13, when the delivery chuck 11 is opened, the delivery chuck 11 retracts to an origin position due to the elastic energy stored in the spring 13. When the receiving unit 50 is advanced in this state, the upper protective sheet C1 and the lower protective sheet C2 gripped by the upper separation chuck 41 and the lower separation chuck 42 are further separated respectively from the adherend body B1.

Next, as shown in Fig. 14, when the receiving chuck 51 is further advanced, the entire upper protective sheet C1 and lower protective sheet C2 gripped by the upper separation chuck 41 and the lower separation chuck 42 are separated from the adherend body B1 (a full separation step S9).

Fig. 15 is a diagram showing a state in which the upper separation chuck 41 and the lower separation chuck 42 grip the upper protective sheet C1 and the lower protective sheet C2 in the protective sheet separation device 1 according to Fig. 14.

From the state shown in Fig. 15, as shown in Fig. 16, the separation chuck rotating cylinder 43 rotates and moves the upper separation chuck 41 and the lower separation chuck 42 to above the dust boxes 44 and 45. Then, the upper separation chuck 41 and the lower separation chuck 42 are opened, and the upper protective sheet C1 and the lower protective sheet C2 are dropped into discard positions in the dust boxes 44 and 45 (S10).

In this case, by blowing air on the upper protective sheet C1 and the lower protective sheet C2 from above, the upper protective sheet C1 and the lower protective sheet C2 may be reliably dropped to the discard positions in the dust boxes 44 and 45. Alternatively, for example, by bringing one or more rod-shaped members (not shown) into contact with the upper protective sheet C1 and the lower protective sheet C2 from above, the upper protective sheet C1 and the lower protective sheet C2 may be reliably dropped to the discard positions in the dust boxes 44 and 45.

### [Operations and effects]

As described above, with the protective sheet separation device 1 according to one aspect of the present invention, it is not necessary to use a rotary drive method in order to separate the upper protective sheet C1 and the lower protective sheet C2 from the adherend body B1, and the protective sheet separation device 1 with a simple configuration can be realized.

Also, it is not necessary to use a rotary drive method to separate the upper protective sheet C1 and the upper separation tape T1, and it is also not necessary to use a rotary drive method to separate the lower protective sheet C2 from the lower separation tape T2. Accordingly, the protective sheet separation device 1 with a simpler configuration can be realized.

In addition, after step S7, the rollers 21 to 25 of the upper tape holding unit 20 and the rollers 31 to 35 of the lower tape holding unit 30 may be rotated reversely. In this case, in step S8, the portion closest to the upper separation chuck 41 among the portions of the upper protective sheet C1 to which the upper separation tape T1 is attached can be easily separated from the upper separation tape T1. Similarly, the portion closest to the lower separation chuck 42 among the portions of the lower protective sheet C2 to which the lower separation tape T2 is attached can be easily separated from the lower separation tape T2. Accordingly, it is possible to more effectively separate the upper protective sheet C1 from the upper separation tape T1, and the lower protective sheet C2 from the lower separation tape T2.

Further, the upper separation chuck 41 grips not a free end of the upper protective sheet C1 but the portion of the upper protective sheet C1 between the portion attached to the upper separation tape T1 and the portion attached to the adherend body B1. Since the positions of the upper separation tape T1 and the adherend body B1 are stable, the position of the portion of the upper protective sheet C1 between the portion attached to the upper separation tape T1 and the portion attached to the adherend body B1 is also stable. Accordingly, the upper separation chuck 41 can stably grip the upper protective sheet C1.

Similarly, the lower separation chuck 42 grips not a free end of the lower protective sheet C2 but the portion of the lower protective sheet C2 between the portion attached to the lower separation tape T2 and the portion attached to the adherend body B1. Accordingly, for the same reason, the lower separation chuck 42 can stably grip the lower protective sheet C2.

Also, the upper tape holding unit 20 moves the upper separation tape T1 relative to the upper attaching roller 23, and the lower tape holding unit 30 moves the lower separation tape T2 relative to the lower attaching roller 33. Thus, separation of the upper protective sheet C1 and the lower protective sheet C2 from the adherend body B1 and movement of the adherend body B1 to the delivery position can be realized at the same time. Accordingly, the protective sheet separation device 1 with a simpler configuration can be realized.

Also, the upper separation chuck 41 and the lower separation chuck 42 can move the upper protective sheet C1 and the lower protective sheet C2 after being separated from the adherend body B1 to the discard positions. Accordingly, it is not necessary to provide a configuration for moving the upper protective sheet C1 and the lower protective sheet C2 separately from the upper protective sheet C1 and the lower protective sheet C2, and the protective sheet separation device 1 with a simpler configuration can be realized.

Also, the upper protective sheet C1 and the lower protective sheet C2 attached respectively to the upper surface and the lower surface of the adherend body B1 can be simultaneously separated from the adherend body B1. Accordingly, separation efficiency of the protective sheet separation device 1 can be improved.

Further, the protective sheet separation device may be configured to include: an attaching unit to which a separation tape is attached and which is movable relative to an adherend body to which a protective sheet is attached; a gripping unit which grips a separated portion of the protective sheet that is separated from the adherend body and is not attached to the separation tape; a moving unit that holds the adherend body and is movable relative to the gripping unit; and a control unit that controls the attaching unit, the gripping unit, and the moving unit such that the separation tape is pressed and attached to the protective sheet by performing a relative movement of the attaching unit in a direction of coming closer to the adherend body, then the separated portion is generated by performing a relative movement of the attaching unit in a direction of moving away from the adherend body, the gripping unit grips the separated portion, the moving unit holds the adherend body by performing a relative movement of the moving unit in a direction of coming closer to the gripping unit, and then the entire protective sheet is separated from the adherend body by performing a relative movement of the moving unit in a direction of moving away from the gripping unit.

### §4 Modified example

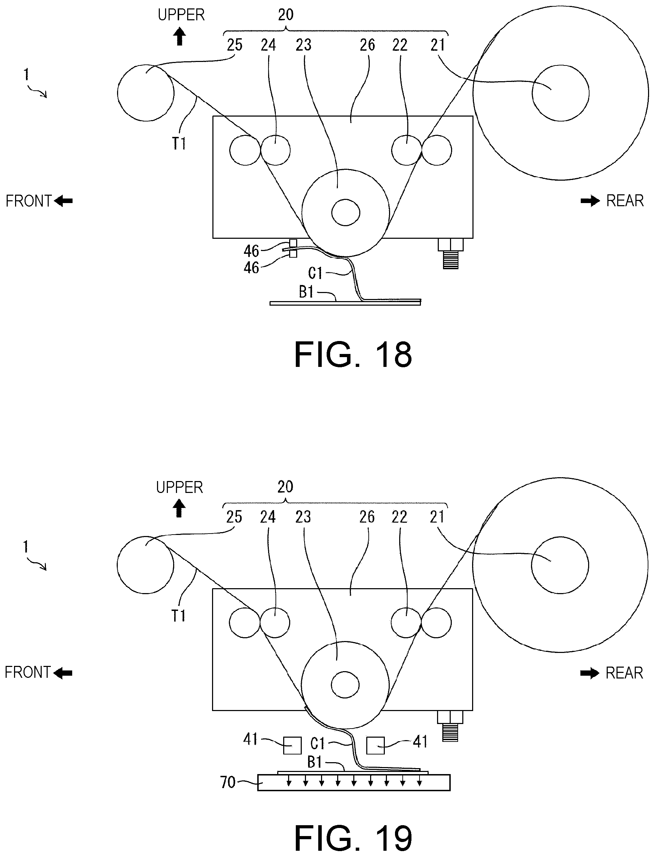

As shown in Fig. 18, the protective sheet separation device 1 may include an upper separation chuck 46 instead of the upper separation chuck 41. The upper separation chuck 41 grips the portion of the upper protective sheet C1 between the portion attached to the upper separation tape T1 and the portion attached to the adherend body B1. On the other hand, the upper separation chuck 46 grips the free end of the upper protective sheet C1.

In this case, in step S3 shown in Fig. 17, the upper attaching roller 23 presses the upper separation tape T1 to be attached to a portion closer to a center of the upper protective sheet C1 than the front end portion. Then, as shown in step S6, the upper attaching roller 23 may be relatively moved in the direction of moving away from the adherend body B1 to separate the front portion of the upper protective sheet C1 from the adherend body B1, and then the upper separation chuck 46 may grip the free end of the upper protective sheet C1.Similarly, the protective sheet separation device 1 may include a lower separation chuck that grips the free end of the lower protective sheet C2 instead of the lower separation chuck 42.

Also, as shown in Fig. 19, the protective sheet separation device 1 may include a moving unit 70 instead of the receiving unit (moving unit) 50. The receiving unit 50 holds the portion of the adherend body B1 from which the upper protective sheet C1 and the lower protective sheet C2 have been separated. On the other hand, the moving unit 70 sucks and holds one surface of the adherend body B1.

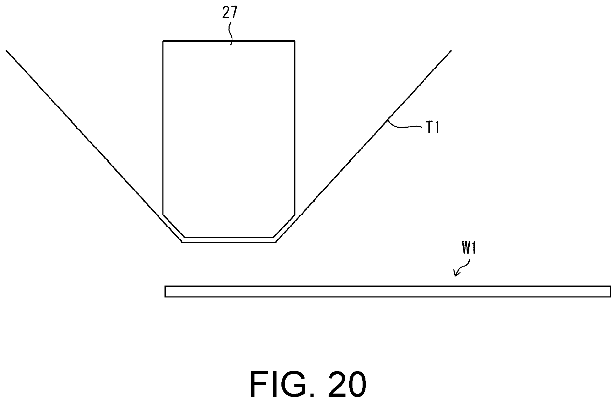

Also, as shown in Fig. 20, the protective sheet separation device 1 may include an upper attaching unit 27 instead of the upper attaching roller 23. The upper attaching unit 27 is a member that has, for example, a prismatic shape and presses the upper separation tape T1 against the upper protective sheet C1 on the adherend body B1. In a case in which the upper attaching unit 27 has a prismatic shape, a side thereof in contact with the upper separation tape T1 is preferably chamfered. Further, the upper attaching unit 27 does not have to rotate. In addition, although not shown, the protective sheet separation device 1 may similarly include a lower attaching unit having the same configuration as the upper attaching unit 27 instead of the lower attaching roller 33.

### [Summary]

A protective sheet separation device according to one aspect of the present invention includes: an attaching unit to which a separation tape is attached, which is movable relative to an adherend body to which a protective sheet is attached, and which presses the separation tape to be attached to the protective sheet by performing a relative movement in a direction of coming closer to the adherend body; a gripping unit that grips a portion of the protective sheet that has been separated from the adherend body by performing a relative movement of the attaching unit in a direction of moving away from the adherend body and is not attached to the separation tape; and a moving unit that is movable relative to the gripping unit, holds the adherend body, and separates the entire protective sheet from the adherend body by performing a relative movement in a direction of moving away from the gripping unit.

According to the above configuration, when the attaching unit presses the separation tape to be attached to the protective sheet, and then moves relative to the protective sheet in the direction of moving away from the adherend body, the protective sheet is partially separated from the adherend body. In this case, the gripping unit grips the portion of the protective sheet that is separated from the adherend body and is not attached to the separation tape. In this state, when the moving unit holding the adherend body moves relative to the gripping unit in the direction of moving away from the gripping unit, the protective sheet is gripped by the gripping unit and cannot follow movement of the adherend body, and thus the entire protective sheet is separated from the adherend body. Accordingly, it is not necessary to use a rotary drive method to separate the protective sheet from the adherend body, and the protective sheet separation device with a simple configuration can be realized.

In the protective sheet separation device according to the one aspect, the attaching unit may move away from the gripping unit by performing the relative movement in the direction of moving away from the adherend body and separate the protective sheet gripped by the gripping unit from the separation tape attached to the attaching unit.

According to the above configuration, when the attaching unit moves relative to the adherend body in a direction of moving further away from the adherend body with the protective sheet gripped by the gripping unit, the attaching unit separates the protective sheet gripped by the gripping unit from the separation tape attached to the attaching unit. Accordingly, it is not necessary to use a rotary drive method to separate the protective sheet from the separation tape, and the protective sheet separation device with a simpler configuration can be realized.

The protective sheet separation device according to the one aspect may further include a tape drive unit that moves the separation tape attached to the attaching unit relative to the attaching unit, the attaching unit may be an attaching roller, and the tape drive unit may move the separation tape relatively such that a portion farthest from the gripping unit among portions of the protective sheet to which the separation tape has been attached comes closer to a position of a portion closest to the gripping unit among the portions of the protective sheet to which the separation tape has been attached.

According to the above configuration, when the protective sheet and the separation tape are separated, the portion closest to the gripping unit among the portions of the protective sheet to which the separation tape is attached is easily separated from the separation tape. Accordingly, the protective sheet and the separation tape can be separated more effectively.

In the protective sheet separation device according to the one aspect, the gripping unit may grip a portion of the protective sheet partially separated from the adherend body between a portion that has been attached to the separation tape and a portion that has been attached to the adherend body.

According to the above configuration, the gripping unit grips not the free end of the protective sheet but the portion of the protective sheet between the portion attached to the separation tape and the portion attached to the adherend body. Since the positions of the separation tape and the adherend body are stable, the position of the portion of the protective sheet between the portion attached to the separation tape and the portion attached to the adherend body is also stable. Accordingly, the gripping unit can stably grip the protective sheet.

The protective sheet separation device according to the one aspect may further include a tape drive unit that moves the separation tape attached to the attaching unit relative to the attaching unit, and the tape drive unit may move the separation tape relative to the attaching unit, thereby separating a portion of the protective sheet from the adherend body and moving the adherend body to a delivery position at which the adherend body can be held by the moving unit.

According to the above configuration, the tape drive unit moves the separation tape relative to the attaching unit, and thus separation of the protective sheet from the adherend body and movement of the adherend body to the delivery position are realized at the same time. Accordingly, the protective sheet separation device with a simpler configuration can be realized.

In the protective sheet separation device according to the one aspect, the gripping unit may move the protective sheet after being separated from the adherend body to a predetermined position. According to the above configuration, the gripping unit can move the protective sheet after being separated from the adherend body to, for example, a discard position for discarding the protective sheet. Accordingly, it is not necessary to provide a configuration for moving the protective sheet separately from the gripping unit, and the protective sheet separation device with a simpler configuration can be realized.

In the protective sheet separation device according to the one aspect, the separation tape which is pressed and attached to each of two protective sheets that have been attached to two surfaces of the adherend body may be attached to the attaching unit, the gripping unit may respectively grip the two protective sheets, and the moving unit may hold a portion of the adherend body from which the two protective sheets have been separated.

According to the above configuration, even in a case in which two protective sheets are attached to two surfaces of the adherend body, the two protective sheets can be separated from the adherend body at the same time. Accordingly, separation efficiency of the protective sheet separation device can be improved.

Further, a protective sheet separation method according to one aspect of the present invention includes: an attaching step of pressing a separation tape to be attached to a protective sheet that has been attached to an adherend body; a partial separation step of relatively moving the separation tape in a direction of moving away from the adherend body to partially separate the protective sheet from the adherend body; a gripping step of gripping a portion of the protective sheet, which has been separated from the adherend body and is not attached to the separation tape, using a gripping unit; and a full separation step of relatively moving the adherend body in a direction of moving away from the gripping unit, thereby separating the entire protective sheet from the adherend body.

The protective sheet separation method according to the one aspect may further include a separation step of moving a portion of the separation tape attached to the protective sheet relative to the gripping unit in a direction of moving away from the gripping unit, thereby separating the separation tape and the protective sheet.

It should be understood that the present invention is not limited to the above-described embodiments and various modifications can be made within the scope of the claims, and that the technical scope of the present invention also includes embodiments obtained by appropriately combining technical means disclosed in the different embodiments.

### [Reference Signs List]

1 Protective sheet separation device
10 Delivery unit
11 Delivery chuck
20 Upper tape holding unit (tape drive unit)
23 Upper attaching roller (attaching unit)
30 Lower tape holding unit (tape drive unit)
33 Lower attaching roller (attaching unit)
41 Upper separation chuck (gripping unit)
42 Lower separation chuck (gripping unit)
50 Receiving unit (moving unit)
51 Receiving chuck
60 Control unit
B1 Adherend body
C1 Upper protective sheet
C2 Lower protective sheet
T1 Upper separation tape
T2 Lower separation tape
W1 Workpiece

## Claims

1. A protective sheet separation device, comprising:
an attaching unit to which a separation tape is attached, which is movable relative to an adherend body to which a protective sheet is attached, and which presses the separation tape to be attached to the protective sheet by performing a relative movement in a direction of coming closer to the adherend body;
a gripping unit that grips a portion of the protective sheet that has been separated from the adherend body by performing the relative movement of the attaching unit in a direction of moving away from the adherend body and is not attached to the separation tape; and
a moving unit that is movable relative to the gripping unit, holds the adherend body, and separates the entire protective sheet from the adherend body by performing the relative movement in a direction of moving away from the gripping unit.

2. The protective sheet separation device according to claim 1, wherein the attaching unit moves away from the gripping unit by performing the relative movement in the direction of moving away from the adherend body and separates the protective sheet gripped by the gripping unit from the separation tape attached to the attaching unit.

3. The protective sheet separation device according to claim 2, further comprising:
a tape drive unit that moves the separation tape attached to the attaching unit relative to the attaching unit,
wherein the attaching unit is an attaching roller, and
the tape drive unit moves the separation tape relatively such that a portion farthest from the gripping unit among portions of the protective sheet to which the separation tape has been attached comes closer to a position of a portion closest to the gripping unit among the portions of the protective sheet to which the separation tape has been attached.

4. The protective sheet separation device according to any one of claims 1 to 3, wherein the gripping unit grips a portion of the protective sheet partially separated from the adherend body between a portion that has been attached to the separation tape and a portion that has been attached to the adherend body.

5. The protective sheet separation device according to claim 3, wherein the tape drive unit moves the separation tape relative to the attaching unit, thereby separating a portion of the protective sheet from the adherend body and moving the adherend body to a delivery position at which the adherend body is able to be held by the moving unit.

6. The protective sheet separation device according to any one of claims 1 to 5, wherein the gripping unit moves the protective sheet after being separated from the adherend body to a predetermined position.

7. The protective sheet separation device according to any one of claims 1 to 6.
wherein the separation tape which is pressed and attached to each of two protective sheets that have been attached to two surfaces of the adherend body is attached to the attaching unit,
the gripping unit respectively grips the two protective sheets, and
the moving unit holds a portion of the adherend body from which the two protective sheets have been separated.

8. A protective sheet separation method, comprising:
an attaching step of pressing a separation tape to be attached to a protective sheet that has been attached to an adherend body;
a partial separation step of relatively moving the separation tape in a direction of moving away from the adherend body to partially separate the protective sheet from the adherend body;
a gripping step of gripping a portion of the protective sheet, which has been separated from the adherend body and is not attached to the separation tape, using a gripping unit; and
a full separation step of relatively moving the adherend body in a direction of moving away from the gripping unit, thereby separating the entire protective sheet from the adherend body.

9. The protective sheet separation method according to claim 8, further comprising:
a separation step of relatively moving a portion of the separation tape attached to the protective sheet in the direction of moving away from the gripping unit, thereby separating the separation tape and the protective sheet.
